Europäisches Patentamt

European Patent Office

Office européen des brevets

(19)

(11) Veröffentlichungsnummer: **0 132 735**
**B1**

(12) **EUROPÄISCHE PATENTSCHRIFT**

(45) Veröffentlichungstag der Patentschrift: **11.04.90**

(21) Anmeldenummer: **84108304.1**

(22) Anmeldetag: **14.07.84**

(51) Int. Cl.⁵: $C\ 23\ C\ 16/40$

(54) **Verfahren zur Anordnung einer Wärmedämmschicht auf einem Metallsubstrat.**

(30) Priorität: **28.07.83 DE 3327216**

(43) Veröffentlichungstag der Anmeldung:
**13.02.85 Patentblatt 85/07**

(45) Bekanntmachung des Hinweises auf die
Patenterteilung:
**11.04.90 Patentblatt 90/15**

(84) Benannte Vertragsstaaten:
**FR GB IT SE**

(56) Entgegenhaltungen:
DE-A-2 317 267
DE-A-2 715 290
GB-A-1 275 044
US-A-3 160 517

JOURNAL OF THE ELECTROCHEMICAL
SOCIETY, Band 118, Nr. 5, Mai 1971, Seiten
747-754, Princeton, New Jersey, US; R.N.
TAUBER et al.: "Preparation and properties of
pyrolytic zirconium dioxide films"

(73) Patentinhaber: **MTU MOTOREN- UND
TURBINEN-UNION MÜNCHEN GMBH
Dachauer Strasse 665 Postfach 50 06 40
D-8000 München 50 (DE)**

(72) Erfinder: **Fitzer, Erich, Prof. Dr.
Haydn-Platz 5
D-7500 Karlsruhe 1 (DE)**
Erfinder: **Brennfleck, Karl, Dr.-rer. nat.
Im Hohen Grund 6
D-7500 Karlsruhe-Grötzingen (DE)**
Erfinder: **Schlichting, Jürgen
deceased (DE)**

**Beschreibung**

Die Erfindung betrifft ein Verfahren zur Anordnung einer Wärmedämmschicht auf einem kompakten Metallsubstrat, welche eine auf dem Substrat befistigte Metallfilzschicht und eine darüber angeordnete Zirkondioxidschicht umfaßt. Zirkondioxid hat sich wegen seiner geringen Wämeleitfähigkeit als gutes Wärmedämmmaterial auch oberhalb von 100°C erwiesen. Bekannt ist die Aufbringung von plasmagespritzten Schichten von Zirkondioxid auf metallische kompakte Substrate. Nachteilig ist jedoch die hohe Restporosität solcher Schichten sowie ihre geringe Verschleißfestigkeit und Haftfähigkeit.

Aus DE—A—2 715 290 ist bekannt, zwischen dem kompakten Metallsubstrat und einer Keramikschutzschicht eine flexible Metallstruktur-Zwischenschicht zu befestigen, um die Wärmeausdehnungsunterschiede auszugleichen und damit die Haftungsprobleme zu lösen. Derartige Lösungen haben den Nachteil einer aufwendigen Befesigung der Metallstruktur-Zwischenschicht sowohl am kompakten Metallsubstrat als auch an der Keramikschutzschicht.

Darüberhinaus ist bekannt, daß das Zirkondioxid als Schutzschicht eines kompakten Substrats wie eines Halbleitermaterials mittels Gasphasenabscheidung gebildet werden kann. Dieses Verfahren nach J. Electrochemical Soc. Vol 118, No. 5, 1971 Seiten 747 bis 754 setzt voraus, daß eine geschlossene Oberfläche für die Abscheidung zur Verfügung steht.

Nachteilig ist bei allen Zirkondioxid-Gasphasenabscheidungsverfahren (CVC-Verfahren) grundsätzlich die schlechte Haftfestigkeit zwischen Schicht und (kompaktem) Metallsubstrat, bedingt durch die unteschiedlichen mechanischen, thermischen und chemischen Eigenschaften der beiden Materialien. Nachteilig ist ferner die geringe Beschichtungsgeschwindigkeit.

Aufgabe der Erfindung ist die Schaffung eines gattungsgemäßen Verfahrens zur Anordnung bzw. Aufbringung einer Wärmedämmschicht auf einem Metallsubstrat, bei dem auf einfache Weise und schnell eine gut haftende Wärmedämmschicht hoher Effizienz auf einem geeigneten Metallsubstrat ausgebildet wird.

Gelöst wird die der Erfindung zugrunde liegende Aufgabe dadurch, daß das Zirkondioxid den Metallfilz aus einem hochtemperatur- und korrosionsfesten Material so infiltriert, daß die Dichte des mittels chemischer Gasphasenabscheidung abgeschiedenen feinkörnigen Zirkondioxids von der Oberfläche des Filzes zum kompakten Metallsubstrat hin abnimmt.

Der Metallfilz selbst kann als Haftvermittler für ein kompaktes Metallsubstrat angezogen werden, beispielsweise aus Nickelbasislegierungen.

Durch Gasphasenabscheidungsverfahren lassen sich erfindungsgemäß sehr feinkörnige und dichte wämedämmende Schichten erzeugen.

Für die Herstellung solcher Zirkondioxidschichten stehen prinzipiell mehrere Verfahren zur Verfügung. Insbesondere erfolgt die Gasphasenabscheidung mit Metallfilzinfiltration über Zirkonchloride, wobei die Hydrolyse von Zirkontetrachlorid mit Wasser, das in einer Sekundärreaktion aus Wasserstoff und Kohlendioxid erzeugt wird, im Hinblick auf die Reakationsgeschwindigkeit und die Variationsbreite beim Mikrogefüge sehr günstige Voraussetzungen mitbringt. Es wurde nun erfindungsgemäß gefunden, daß eine wesentliche Verbesserung der Haftfestigkeit sowie eine Steigerung der Abscheidungsgeschwindigkeit dadurch erreicht werden kann, daß der Metallfilz aus einem hochtemperatur- und korrosionsbeständigen Material, vorzugsweise aus einer Legierung auf Nickel und/oder Kobaltbasis besteht. Bevorzugt sind Legierungen wie NiCr, NiCrAl, Hastelloy $X^R$, NiCrAlY, CoCrAlY zu verwenden. Dieser Mettallfilz, läßt sich so infiltrieren, daß die Dichte des abgeschiedenen Zirkondioxids von der Oberfläche des Filzes zum kompakten Metallsubstrat hin abnahm. Die Restporosität unmittelbar oberhalb der Substratoberfläche vermindert die Spannungen zwischen kompaktem Substrat und Schicht.

Die Imprägnierung eines Filzes hat ferner den Vorzug, daß die Schichtwachstumsgeschwindigkeit infolge der großen inneren Oberfläche stark erhöht wird. Diese Schichtwachstumsgeschwindigkeit kann über die Porosität des Metallfilzes beeinflußt werden. Die Porositäten der im Handel erhältlichen Filze liegen zwischen 45% und 95%.

Beispiel

Als Beispiel sei die Imprägnierung eines Metallfilzes bei 750°C und bei 650°C in einer Heißwandbeschichtungsapparatur angegeben. In beiden Fällen werden die $ZrO_2$-Wärmedämmschichten durch Hydrolyse von $ZrCl_4$ mit Wasser hergestellt.

Der Partialdruck des Zirkontetrachlorids beträgt $10^{-1}$ mbar bei einem Gesamtdruck von 10 mbar, einem Wasserstoffdurchsatz von 5 l/h und einem Kohlendioxiddurchsatz von 2,5 l/h.

Als Abscheidungsgeschwindigkeit wird bei 750°C 30 mg/cm$^3$h und bei 650°C 14 mg/cm$^3$h gemessen.

Stärker als die Abscheidungsgeschwindigkeiten unterscheiden sich jedoch die Eindringtiefen des Zirkondioxids und dessen Mikrogefüge bei den verschiedenen Beschichtungstemperaturen. So läßt sich bei 740°C grobkörniges Zirkondioxid mit einer hohen Restporosität und einer Eindringtiefe von maximal 100 μm ereichen, während bei 650°C das Zirkondioxid über 300 μm eindringt und sich feinkörnige kompakte Schichten ausbilden. Auf diese Weise können vorteilhaft kompakte Metallsubstrate wie Schutzrohre, Düsen und Teile von Turbinen mit einer gut haftenden Wärmeschutzschicht versehen werden.

Durch simultane Verwendung weiterer Oxid bildner z.B. $YCl_3$ lassen sich Mischoxide abscheiden, wodurch bestimmte krisallographische Modifikationen des Zircondioxids z.B. die kubische Form $ZrO_2 . nY_2O_3$ teilweise oder vollstabilisiert abgeschieden werden können.

**Patentansprüche**

1. Verfahren zur Anordnung einer Wärme-dämmschicht auf einem kompakten Metallsub-strat, welche eine auf dem Substrat befestigte Metallfilzschicht und eine darüber angeordnete Zirkondioxidschicht umfaßt, dadurch gekennzeichnet, daß das Zirkondioxid den Metallfilz aus einem hochtemperatur- und korrosionsbeständigen Material so infiltriert, daß die Dichte des mittels chemischer Gasphasenabscheidung abgeschiedenen feinkörnigen Zirkondioxids von der Oberfläche des Filzes zum kompakten Metallsubstrat hin abnimmt.

2. Verfahren nach Anspruch 1, dadurch gekennzeichnet, daß die Gasphasenabscheidung mit Metallfilzinfiltration über Zirkonchloride erfolgt.

3. Verfahren nach Anspruch 1 oder 2, dadurch gekennzeichnet, daß der Metallfilz aus einer Legierung auf Nickel und/oder Kobaltbasis besteht.

4. Verfahren nach den Ansprüchen 1 bis 3, dadurch gekennzeichnet, daß die Gasphasenabscheidung unterhalb 1000°C vorzugsweise im Temperaturbereich zwischen 550°C und 750°C erfolgt.

5. Verfahren nach den Ansprüchen 1 bis 4, dadurch gekennzeichnet, daß bei der Gasphasenabscheidung durch simultane Abscheidung von $Y_2O_3$ teil- oder vollstabilisiertes kubisches $ZrO_2.nY_2O_3$ erzeugt wird.

**Revendications**

1. Procédé pour disposer sur un substrat métallique compact, une couche d'isolation thermique qui comprend une couche de feutre métallique fixée sur le substrat et une couche de zircone disposée par dessus, procédé caractérisé en ce que la zircone infiltre le feutre métallique, constitué d'un matériau résistant à des températures élevées et à la corrosion, de façon que la densité de la zircone à grains fins déposée par précipitation chimique en phase gazeuse, décroît en partant de la surface du feutre vers le substrat métallique compact.

2. Procédé selon la revendication 1, caractérisé en ce que la précipitation en phase gazeuse avec infiltration du feutre métallique, s'effectue par l'intermédiaire de chlorure de zirconium.

3. Procédé selon la revendication 1 ou la revendication 2, caractérisé en ce que le feutre métallique est constitué par un alliage à base de nickel et/ou de cobalt.

4. Procédé selon les revendications 1 à 3, caractérisé en ce que la précipitation en phase gazeuse s'effectue au-dessous de 1000°C, de préférence dans une étendue de température entre 550°C et 750°C.

5. Procédé selon les revendications 1 à 4, caractérisé en ce que, lors de la précipitation en phase gazeuse, on obtient par précipitation simul-tanée de $Y_2O_3$ partiellement stabilisé ou de $ZrO_2.nYO_3$ cubique complètement stabilisé.

**Claims**

1. Process for arranging a heat insulating layer on a compact metal substrate, which heat insulating layer comprises a metal felt layer, which is secured to the substrate, and a zircon dioxide layer disposed thereabove, characterised in that the zircon dioxide infiltrates the metal felt, consisting of a material which is resistant to high temperatures and corrosion, in such a way that the density of the fine-grained zircon dioxide, separated by means of chemical gaseous phase precipitation, decreased from the surface of the felt to the compact metal substrate.

2. Process as claimed in claim 1, characterised in that the gaseous phase precipitation occurs with metal felt infiltration by way of zircon chloride.

3. Process as claimed in claim 1 or claim 2, characterised in that the metal felt consists of an alloy on a nickel and/or cobalt basis.

4. Process as claimed in claims 1 to 3, characterised in that the gaseous phase precipitation occurs below 1000°C preferably in the temperature range between 550°C and 750°C.

5. Process as claimed in claims 1 to 4, characterised in that, in the gaseous phase precipitation, partially or fully stabilised cubic $ZrO_2.nY_2O_3$ is produced by simultaneous precipitation of $Y_2O_3$.